# EUROPEAN PATENT APPLICATION

(11) **EP 2 634 765 A2**
(43) Date of publication of application: **04.09.2013**
(21) Application number: 11816599.2
(22) Date of filing: 10.08.2011
(51) Int. Cl.: G09F 9/00

(54) **ROLL-TYPE FLEXIBLE DEVICE FOR DISPLAYING**

(30) Priority: 03.08.2011 KR 20110077320; 10.08.2010 KR 20100077078
(71) Applicant: Ryu, Sang-Kyu, Gyeonggi-do 437-727 (KR)
(72) Inventor: Ryu, Sang-Kyu, Gyeonggi-do 437-727 (KR)
(74) Representative: Mittler, Enrico
(86) International application number: PCT/KR2011/005839
(87) International publication number: WO 2012/020983

(57) **Abstract**

The present invention discloses a roll-type flexible device for displaying, comprising: a body housing in which a flexible display portion is accommodated so as to be wound and unwound; a length adjusting member, which is mounted on the body housing for maintaining the flexible display portion in an unrolled state, and which has an extendable structure by being linked to the unwinding of the flexible display portion; and a fixing member for fixing the extended length of the length adjusting member.

## Description

### CROSS-REFERENCE TO RELATED APPLICATION

This application claims the benefit of Korean Patent Application No.10-2010-0077078, filed on August 10, 2010 and Korean Patent Application No.10-2011-0077320, filed on August 3, 2011 in the Korean Intellectual Property Office, the disclosure of which is incorporated herein by reference.

### Technical Field

The present invention relates to a flexible display device, and more particularly, to a roll-type flexible display device that can adjust a length.

### Background Art

A roll-type flexible display device has a structure that stores a flexible display by winding within a body housing and that can use the flexible display by extending, as needed and can reduce a bulk of the device, compared with a screen size even while easily carrying and has been thus spotlighted as a future generation display.

Patent Documents related to a roll-type flexible display device may include, for example, Korean Registration Patent No. 818170 and Korean Publication Patent Application No. 2009-0076996.

Korean Registration Patent No. 818170 discloses a roll-type flexible display device including a display driver mounted to one side or both sides of an individual portable information terminal and that may be connected and fixed to the individual portable information terminal, and the display driver includes a fixing member, a rotation case for performing a function of a support shaft that can wind a flexible display, and a coil spring for providing elastic restoring force.

Korean Publication Patent Application No. 2009-0076996 discloses a wrap display system that is formed to wrap a flexible display to a stick circumference and that selects a hinge type frame that supports the flexible display.

However, in a conventional roll-type flexible display device such as Korean Registration Patent No. 818170, a fixing means for maintaining an extended state of a flexible display is weak and thus it is inconvenient to use the flexible display, and particularly, it is very difficult to perform a manipulation such as a multi touch.

In a method of supporting a flexible display using a hinge type frame such as Korean Publication Patent Application No. 2009-0076996, it is difficult to apply the flexible display to a large screen display, and a length of a screen to extend cannot be freely adjusted.

### Disclosure of Invention

The present invention is made to overcome the above mentioned problems, and it is an object of the present invention to provide a roll-type flexible display device having a structure that can fix on a step basis an extended state of a flexible display that can adjust a length.

It is another object of the present invention to provide a roll-type flexible display device having a structure that can cover a fixing means of an extended state of a flexible display.

### Technical Solution

To achieve the above objects, there is provided a roll-type flexible display device including: a body housing in which a flexible display portion is housed to be wound and unwound; a length adjusting member that is connected to the body housing and in which the flexible display portion maintains an extended state and that has an extendable structure by interlock with unwinding of the flexible display portion; and a fixing member that fixes an extended length of the length adjusting member.

The length adjusting member may have a foldable rod assembly.

The rod assembly may have a rod pair for rotating using a first hinge as an intermediary and crossing in an 'X' shape.

A rod constituting the rod assembly may have a multistage pipe structure having an extendable length.

In the rod assembly, a rod pair crossing in the 'X' shape may have a structure connected with a chain method in plural using a second hinge as an intermediary.

Alternatively, the rod assembly may rotate using a joint as an intermediary and have a structure in which a foldable '>'-shaped rod pair and '<'-shaped rod pair are connected.

In the body housing, a guide portion for sliding an end portion of a rod pair positioned at both ends of the length adjusting member in a width direction of the flexible display portion by interlocking with length adjustment of the flexible display portion may be provided.

In the guide portion, a guide rail extended in a length direction may be provided, and in an end portion of the rod pair, a slider slidably coupled along the guide rail may be provided.

Preferably, the fixing member fixes the slider to the guide rail on a step basis.

Preferably, the fixing member includes a stopper that provides a stopping function of a predetermined click when a rod pair constituting the rod assembly rotate.

The body housings may be connected to each of both ends of the length adjusting member, and in one of the body housings connected to the both ends of the length adjusting member, the flexible display portion may be housed, and in the other one thereof, a screen member for covering the length adjusting member may be housed to be wound and unwound.

The screen member may use a flexible display or a film of a cloth or synthetic resin material.

### Advantageous effects

According to the present invention, because an extended state of a flexible display can be maintained and fixed by a length adjusting member, use convenience of a roll-type flexible display device can be improved.

According to another aspect of the present invention, an extended length of a flexible display can be freely adjusted and fixed, as needed.

According to another aspect of the present invention, while a flexible display is extended, a length adjusting member is covered by a screen member, thereby protecting from the outside. Here, when the flexible display is adapted as the screen member, while covering the length adjusting member, a both surface flexible display device can be embodied.

### Brief Description of Drawings

For a better understanding of the invention as well as other objects and features thereof, reference is made to the following detailed description to be read in conjunction with the accompanying drawings, wherein:
FIGS. 1 and 2 are diagrams illustrating a structure before and after extension of a roll-type flexible display device according to an exemplary embodiment of the present invention.
FIG. 3 is a rear view illustrating a structure of a roll-type flexible display device according to an exemplary embodiment of the present invention.
FIG. 4 is a view illustrating a structure of another example of a length adjusting member in FIG. 3.
FIG. 5 is a view illustrating a structure of another example of a length adjusting member in FIG. 3.
FIG. 6 is a perspective view illustrating a structure of a guide portion in FIG. 3.
FIGS. 7 and 8 are cross-sectional views illustrating before and after operation of a fixing member provided in the present invention.
FIG. 9 is a side view illustrating another structure of a fixing member provided in the present invention.
FIG. 10 is a top plan view illustrating a structure of a screen member provided in a roll-type flexible display device according to an exemplary embodiment of the present invention.
FIG. 11 is a rear view of FIG.10.

### Best modes for carrying out the invention

Hereinafter, exemplary embodiments of the present invention are described in detail with reference to the accompanying drawings. While the present invention may be embodied in many different forms, specific embodiments of the present invention are shown in drawings and are described herein in detail, with the understanding that the present disclosure is to be considered as an exemplification of the principles of the invention and is not intended to limit the invention to the specific embodiments illustrated. Detailed descriptions of well-known functions and structures incorporated herein may be omitted to avoid obscuring the subject matter of the present invention.

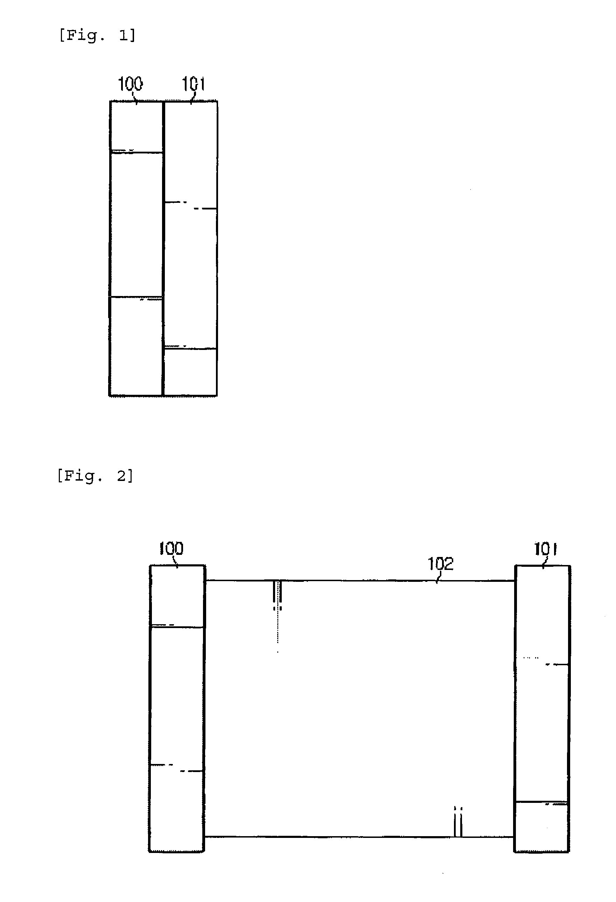

FIGS. 1 and 2 are diagrams illustrating a structure before and after unwinding of a roll-type flexible display device according to an exemplary embodiment of the present invention. As shown in the drawings, a roll-type flexible display device according to an exemplary embodiment of the present invention includes a flexible display portion 102 and a body housing 100 that houses the flexible display portion 102.

The flexible display portion 102 is housed to be wound and unwound within the body housing 100. For this purpose, at the inside of the body housing 100, a predetermined roller (not shown) connected to one end of the flexible display portion 102 to wind the flexible display portion 102 in a circle shape and a predetermined elastic means (not shown) for providing a restoring force when the roller rotates to unwind the flexible display portion 102 are provided. Such constituent elements are well known in a general roll-type flexible display device and therefore a detailed description thereof will be omitted.

When the flexible display portion 102 is unwound, a body housing 101 connected to the other end of the flexible display portion 102 is used as handle for pulling the flexible display portion 102. Alternatively, the body housing 101 connected to the other end of the flexible display portion 102 may be formed to house to be wound and unwound a half of the flexible display portion 102.

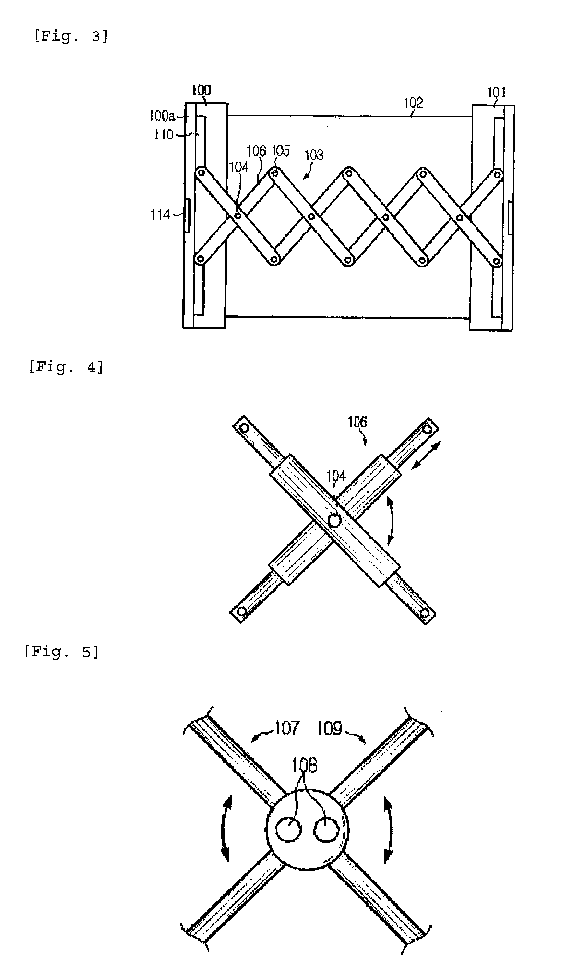

FIG. 3 is a rear view illustrating a structure of a roll-type flexible display device according to an exemplary embodiment of the present invention. As shown in FIG. 3, a roll-type flexible display device according to an exemplary embodiment of the present invention includes a length adjusting member 103 connected to the body housings 100 and 101 of both sides at a rear surface of the flexible display portion 102 to maintain an extended state of the flexible display portion 102 and a fixing member for selectively fixing an extended length of the length adjusting member 103.

The length adjusting member 103 is extended to interlock with unwinding of the flexible display portion 102 and includes a foldable rod assembly. Specifically, the rod assembly has a structure in which a rod pair crossing in an 'X' shape using a first hinge 104 as an intermediary are connected with an organic and chain method using a second hinge 105 as an intermediary.

When the length adjusting member 103 is extended, as 'X'-shaped rod pairs rotate using the first hinge 104 and the second hinge 105 as an intermediary, a height of the 'X'-shaped rod pairs is lowered and thus two end portions (hereinafter, end portions) of a rod pair positioned at the outermost edge of the length adjusting member 103 move in an approaching direction. In contrast, when the length adjusting member 103 is contracted, as 'X'-shaped rod pairs rotate using the first hinge 104 and the second hinge 105 as an intermediary, a height of the 'X'-shaped rod pairs is increased and thus the end portions of a rod pair positioned at the outermost edge of the length adjusting member 103 move in a separating direction.

FIG. 4 illustrates another structure of a rod assembly provided in the length adjusting member 103. Referring to FIG. 4, the rod assembly includes a single rod pair crossing in an 'X' shape using the first hinge 104 as an intermediary. In this case, it is preferable that a rod 106 constituting the rod assembly has a multistage pipe structure having an extendable length. When the length adjusting member 103 is extended, as 'X'-shaped rod pairs rotate using the first hinge 104 as an intermediary, a height of the 'X'-shaped rod pairs is lowered and a multistage pipe of each rod 106 is long extended and simultaneously the end portions of the rod pair move in an approaching direction. In contrast, when the length adjusting member 103 is contracted, as 'X'-shaped rod pairs rotate using the first hinge 104 as an intermediary, a height of the 'X'-shaped rod pairs is increased and a multistage pipe of each rod 106 is shortly contracted and simultaneously the end portions of the rod pair move in a separating direction.

FIG. 5 illustrates another structure of the length adjusting member 103 that may be applied to the present invention. As shown in the drawing, a rod assembly of the length adjusting member 103 have a structure in which a '>'-shaped rod pair 107 and a '<'-shaped rod pair 109 that may be folded by rotating using a joint 108 as an intermediary are connected in an opposite direction. In this case, the '>'-shaped rod pair 107 and the '<'-shaped rod pair 109 are independently folded or extended. When the length adjusting member 103 is extended, the '>'-shaped rod pair 107 and the '<'-shaped rod pair 108 are folded, and simultaneously end portions of the both rod pairs 107 and 109 move in an approaching direction. In contrast, the length adjusting member 103 is contracted, the '>'-shaped rod pair 107 and the '<'-shaped rod pair 109 are extended, and simultaneously end portions of the both rod pairs 107 and 109 move in a separating direction.

In an end portion of a rod pair positioned at the outermost edge of the length adjusting member 103, a predetermined shape of slider 110 integrally moving with the end portion is provided, and in the body housing 100, a guide portion 100a for slidably housing the slider 110 is provided.

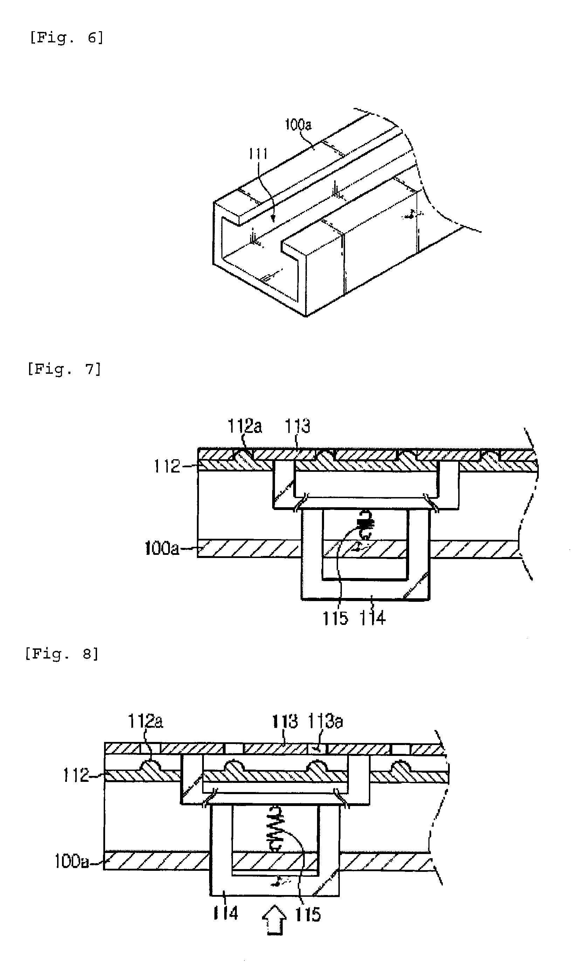

As shown in FIG. 6, it is preferable that the guide portion 100a has a structure in which a guide rail 111 is formed. The guide portion 100a guides the slider 110 to slide in a length direction of the body housing 100, i.e., a width direction of the flexible display portion 102 by interlocking with length adjustment of the flexible display portion 102. FIG. 3 illustrates an external appearance of a side surface of the guide portion 100a.

FIG. 7 illustrates a structure example of a fixing member for fixing the slider 110 to the guide portion 100a on a step basis. Referring to FIG. 7, the fixing member includes a fixing plate 112 that is housed at the inside of the guide portion 100a and in which latch protrusions 112a are formed at a predetermined gap in a length direction, a moving plate 113 that integrally moves with the slider 110 at the inside of the guide portion 100a and in which through-holes 113a are formed at a predetermined gap, and a button portion 114 having a portion installed to be exposed at the outside of the body housing 100 to selectively couple the moving plate to the fixing plate 112.

When the button portion 114 is not manipulated, a state in which the latch protrusion 112a of the fixing plate 112 is inserted into the through-hole 113a of the moving plate 113 is maintained by an elastic force of an elastic body 115, as shown in FIG. 7. Therefore, the slider 110 is fixed without moving in a length direction of the guide portion 100a.

When the button portion 114 is manipulated, the moving plate 113 is separated from the fixing plate 112 by interlocking with the button portion 114 and thus the latch protrusion 112a is separated from the through-hole 113a, as shown in FIG. 8. Therefore, the slider 110 may freely move in a length direction of the guide portion 100a.

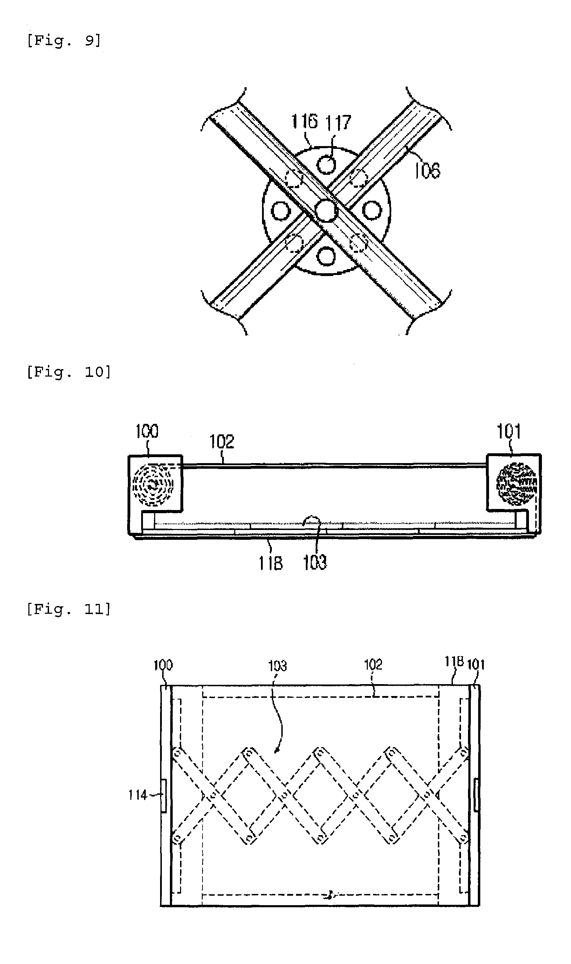

FIG. 9 illustrates another structure of a fixing member provided in the present invention. Referring to FIG. 9, the fixing member includes a stopper 117 that provides a stopping function on a step basis every predetermined click when a rod pair constituting a rod assembly rotate. The stoppers 117 are arranged in plural in a predetermined support body 116 in a circular shape at a predetermined gap and have a structure pushed out by the rotating rod 106 and restored by an elastic force. Such stoppers 117 may have a protrusion structure supported by a predetermined elastic body or may be provided in a saw tooth form geared with the support body.

In addition, the fixing member may be provided in a nipper form mounted in the body housing 100 to pick up and fix the slider 110.

FIGS. 10 and 11 illustrate a structure of a screen member 118 added to a roll-type flexible display device according to an exemplary embodiment of the present invention.

Referring to FIGS. 10 and 11, at one side body housing 100 of a pair of body housings 100 and 101 connected to both ends of the length adjusting member 103, the flexible display portion 102 is housed, and at the other side body housing 101, a screen member 118 is housed.

The screen member 118 covers the length adjusting member 103 exposed at a rear surface of the flexible display portion 102 and may be preferably provided by a film of a cloth material or a synthetic resin material. Alternatively, the screen member 118 may be formed by a second flexible display. In this case, a both surface flexible display device may be formed with the length adjusting member 103 interposed therebetween.

It is preferable that the screen member 118 is housed to be wound and unwound within the body housing 101, similar to the flexible display portion 102. According to such a structure, in order to extend the flexible display portion 102, as two body housings 100 and 101 are separated, while the flexible display portion 102 is extended, the length adjusting member 103 is covered by the screen member 118 and thus the length adjusting member 103 can be protected from the outside and it is advantageous in improving an appearance of a display device.

As the present invention may be embodied in several forms without departing from the spirit or essential characteristics thereof, it should also be understood that the above-described examples are not limited by any of the details of the foregoing description, unless otherwise specified, but rather should be construed broadly within its spirit and scope as defined in the appended claims, and therefore all changes and modifications that fall within the meets and bounds of the claims, or equivalences of such meets and bounds are therefore intended to be embraced by the appended claims.

### <Description of reference numerals>

100,101: body housing 102: flexible display portion
103: length adjusting member 104: first hinge
105: second hinge 110: slider
111: guide portion 112: fixing plate
113: moving plate 114: button portion
117: stopper 118: screen member

### Mode for carrying out the invention

Hereinafter, exemplary embodiments of the present invention are described in detail with reference to the accompanying drawings. While the present invention may be embodied in many different forms, specific embodiments of the present invention are shown in drawings and are described herein in detail, with the understanding that the present disclosure is to be considered as an exemplification of the principles of the invention and is not intended to limit the invention to the specific embodiments illustrated. Detailed descriptions of well-known functions and structures incorporated herein may be omitted to avoid obscuring the subject matter of the present invention.

FIGS. 1 and 2 are diagrams illustrating a structure before and after unwinding of a roll-type flexible display device according to an exemplary embodiment of the present invention. As shown in the drawings, a roll-type flexible display device according to an exemplary embodiment of the present invention includes a flexible display portion 102 and a body housing 100 that houses the flexible display portion 102.

The flexible display portion 102 is housed to be wound and unwound within the body housing 100. For this purpose, at the inside of the body housing 100, a predetermined roller (not shown) connected to one end of the flexible display portion 102 to wind the flexible display portion 102 in a circle shape and a predetermined elastic means (not shown) for providing a restoring force when the roller rotates to unwind the flexible display portion 102 are provided. Such constituent elements are well known in a general roll-type flexible display device and therefore a detailed description thereof will be omitted.

When the flexible display portion 102 is unwound, a body housing 101 connected to the other end of the flexible display portion 102 is used as handle for pulling the flexible display portion 102. Alternatively, the body housing 101 connected to the other end of the flexible display portion 102 may be formed to house to be wound and unwound a half of the flexible display portion 102.

FIG. 3 is a rear view illustrating a structure of a roll-type flexible display device according to an exemplary embodiment of the present invention. As shown in FIG. 3, a roll-type flexible display device according to an exemplary embodiment of the present invention includes a length adjusting member 103 connected to the body housings 100 and 101 of both sides at a rear surface of the flexible display portion 102 to maintain an extended state of the flexible display portion 102 and a fixing member for selectively fixing an extended length of the length adjusting member 103.

The length adjusting member 103 is extended to interlock with unwinding of the flexible display portion 102 and includes a foldable rod assembly. Specifically, the rod assembly has a structure in which a rod pair crossing in an 'X' shape using a first hinge 104 as an intermediary are connected with an organic and chain method using a second hinge 105 as an intermediary.

When the length adjusting member 103 is extended, as 'X'-shaped rod pairs rotate using the first hinge 104 and the second hinge 105 as an intermediary, a height of the 'X'-shaped rod pairs is lowered and thus two end portions (hereinafter, end portions) of a rod pair positioned at the outermost edge of the length adjusting member 103 move in an approaching direction. In contrast, when the length adjusting member 103 is contracted, as 'X'-shaped rod pairs rotate using the first hinge 104 and the second hinge 105 as an intermediary, a height of the 'X'-shaped rod pairs is increased and thus the end portions of a rod pair positioned at the outermost edge of the length adjusting member 103 move in a separating direction.

FIG. 4 illustrates another structure of a rod assembly provided in the length adjusting member 103. Referring to FIG. 4, the rod assembly includes a single rod pair crossing in an 'X' shape using the first hinge 104 as an intermediary. In this case, it is preferable that a rod 106 constituting the rod assembly has a multistage pipe structure having an extendable length. When the length adjusting member 103 is extended, as 'X'-shaped rod pairs rotate using the first hinge 104 as an intermediary, a height of the 'X'-shaped rod pairs is lowered and a multistage pipe of each rod 106 is long extended and simultaneously the end portions of the rod pair move in an approaching direction. In contrast, when the length adjusting member 103 is contracted, as 'X'-shaped rod pairs rotate using the first hinge 104 as an intermediary, a height of the 'X'-shaped rod pairs is increased and a multistage pipe of each rod 106 is shortly contracted and simultaneously the end portions of the rod pair move in a separating direction.

FIG. 5 illustrates another structure of the length adjusting member 103 that may be applied to the present invention. As shown in the drawing, a rod assembly of the length adjusting member 103 have a structure in which a '>'-shaped rod pair 107 and a '<'-shaped rod pair 109 that may be folded by rotating using a joint 108 as an intermediary are connected in an opposite direction. In this case, the '>'-shaped rod pair 107 and the '<'-shaped rod pair 109 are independently folded or extended. When the length adjusting member 103 is extended, the '>'-shaped rod pair 107 and the '<'-shaped rod pair 108 are folded, and simultaneously end portions of the both rod pairs 107 and 109 move in an approaching direction. In contrast, the length adjusting member 103 is contracted, the '>'-shaped rod pair 107 and the '<'-shaped rod pair 109 are extended, and simultaneously end portions of the both rod pairs 107 and 109 move in a separating direction.

In an end portion of a rod pair positioned at the outermost edge of the length adjusting member 103, a predetermined shape of slider 110 integrally moving with the end portion is provided, and in the body housing 100, a guide portion 100a for slidably housing the slider 110 is provided.

As shown in FIG. 6, it is preferable that the guide portion 100a has a structure in which a guide rail 111 is formed. The guide portion 100a guides the slider 110 to slide in a length direction of the body housing 100, i.e., a width direction of the flexible display portion 102 by interlocking with length adjustment of the flexible display portion 102. FIG. 3 illustrates an external appearance of a side surface of the guide portion 100a.

FIG. 7 illustrates a structure example of a fixing member for fixing the slider 110 to the guide portion 100a on a step basis. Referring to FIG. 7, the fixing member includes a fixing plate 112 that is housed at the inside of the guide portion 100a and in which latch protrusions 112a are formed at a predetermined gap in a length direction, a moving plate 113 that integrally moves with the slider 110 at the inside of the guide portion 100a and in which through-holes 113a are formed at a predetermined gap, and a button portion 114 having a portion installed to be exposed at the outside of the body housing 100 to selectively couple the moving plate to the fixing plate 112.

When the button portion 114 is not manipulated, a state in which the latch protrusion 112a of the fixing plate 112 is inserted into the through-hole 113a of the moving plate 113 is maintained by an elastic force of an elastic body 115, as shown in FIG. 7. Therefore, the slider 110 is fixed without moving in a length direction of the guide portion 100a.

When the button portion 114 is manipulated, the moving plate 113 is separated from the fixing plate 112 by interlocking with the button portion 114 and thus the latch protrusion 112a is separated from the through-hole 113a, as shown in FIG. 8. Therefore, the slider 110 may freely move in a length direction of the guide portion 100a.

FIG. 9 illustrates another structure of a fixing member provided in the present invention. Referring to FIG. 9, the fixing member includes a stopper 117 that provides a stopping function on a step basis every predetermined click when a rod pair constituting a rod assembly rotate. The stoppers 117 are arranged in plural in a predetermined support body 116 in a circular shape at a predetermined gap and have a structure pushed out by the rotating rod 106 and restored by an elastic force. Such stoppers 117 may have a protrusion structure supported by a predetermined elastic body or may be provided in a saw tooth form geared with the support body.

In addition, the fixing member may be provided in a nipper form mounted in the body housing 100 to pick up and fix the slider 110.

FIGS. 10 and 11 illustrate a structure of a screen member 118 added to a roll-type flexible display device according to an exemplary embodiment of the present invention.

Referring to FIGS. 10 and 11, at one side body housing 100 of a pair of body housings 100 and 101 connected to both ends of the length adjusting member 103, the flexible display portion 102 is housed, and at the other side body housing 101, a screen member 118 is housed.

The screen member 118 covers the length adjusting member 103 exposed at a rear surface of the flexible display portion 102 and may be preferably provided by a film of a cloth material or a synthetic resin material. Alternatively, the screen member 118 may be formed by a second flexible display. In this case, a both surface flexible display device may be formed with the length adjusting member 103 interposed therebetween.

It is preferable that the screen member 118 is housed to be wound and unwound within the body housing 101, similar to the flexible display portion 102. According to such a structure, in order to extend the flexible display portion 102, as two body housings 100 and 101 are separated, while the flexible display portion 102 is extended, the length adjusting member 103 is covered by the screen member 118 and thus the length adjusting member 103 can be protected from the outside and it is advantageous in improving an appearance of a display device.

As the present invention may be embodied in several forms without departing from the spirit or essential characteristics thereof, it should also be understood that the above-described examples are not limited by any of the details of the foregoing description, unless otherwise specified, but rather should be construed broadly within its spirit and scope as defined in the appended claims, and therefore all changes and modifications that fall within the meets and bounds of the claims, or equivalences of such meets and bounds are therefore intended to be embraced by the appended claims.

### Industrial Applicability

According to the present invention, because an extended state of a flexible display can be maintained and fixed by a length adjusting member, use convenience in various environments such as a moving environment of a roll-type flexible display device can be improved.

According to another aspect of the present invention, because an extended length of a flexible display can be freely adjusted and fixed, as needed, a flexible display device that conveniently change various sizes of displays can be produced.

According to another aspect of the present invention, while a flexible display is extended, a length adjusting member is covered by a screen member, thereby protecting from the outside. Here, when the flexible display is adapted as the screen member, while covering the length adjusting member, a both surface flexible display device can be embodied. Although exemplary embodiments of the present invention have been described in detail hereinabove, it should be clearly understood that many variations and modifications of the basic inventive concepts herein described, which may appear to those skilled in the art, will still fall within the spirit and scope of the exemplary embodiments of the present invention as defined in the appended claims.

## Claims

1. A roll-type flexible display device, comprising:
a body housing in which a flexible display portion is housed to be wound and unwound;
a length adjusting member that is connected to the body housing and in which the flexible display portion maintains an extended state and that has an extendable structure by interlock with unwinding of the flexible display portion; and
a fixing member that fixes an extended length of the length adjusting member.

2. The roll-type flexible display device of claim 1, wherein the length adjusting member has a foldable rod assembly.

3. The roll-type flexible display device of claim 2, wherein the rod assembly has a rod pair for rotating using a first hinge as an intermediary and crossing in an 'X' shape.

4. The roll-type flexible display device of claim 3, wherein a rod constituting the rod assembly has a multistage pipe structure having an extendable length.

5. The roll-type flexible display device of claim 3, wherein in the rod assembly, a rod pair crossing in the 'X' shape are connected with a chain method in plural using a second hinge as an intermediary.

6. The roll-type flexible display device of claim 2, wherein the rod assembly has a structure that rotates using a joint as an intermediary and in which a foldable '>'-shaped rod pair and '<'-shaped rod pair are connected.

7. The roll-type flexible display device of any one of claims 3 to 6, wherein in the body housing, a guide portion for sliding an end portion of a rod pair positioned at both ends of the length adjusting member in a width direction of the flexible display portion by interlocking with length adjustment of the flexible display portion is provided.

8. The roll-type flexible display device of claim 7, wherein in the guide portion, a guide rail extended in a length direction is provided, and
in an end portion of the rod pair, a slider slidably coupled along the guide rail is provided.

9. The roll-type flexible display device of claim 8, wherein the fixing member fixes the slider to the guide rail on a step basis.

10. The roll-type flexible display device of claim 7, wherein the fixing member includes a stopper for providing a stopping function of a predetermined click when a rod pair constituting the rod assembly rotate.

11. The roll-type flexible display device of claim 1, wherein the body housings are connected to each of both ends of the length adjusting member, and
in one of the body housings connected to the both ends of the length adjusting member, the flexible display portion is housed, and in the other one thereof, a screen member for covering the length adjusting member is housed to be wound and unwound.

12. The roll-type flexible display device of claim 11, wherein the screen member is a flexible display or a film of a cloth or synthetic resin material.
